# EUROPÄISCHE PATENTANMELDUNG

(11) **EP 3 680 673 A1**
(43) Veröffentlichungstag der Anmeldung: **15.07.2020**
(21) Anmeldenummer: 19215991.1
(22) Anmeldetag: 13.12.2019
(51) Int. Cl.: G01R 19/165, H02H 1/00, H02H 3/08, H02H 3/38, H02H 7/26, G01R 15/04, G01R 19/00

(54) **SCHUTZANORDNUNG ZUR ÜBERWACHUNG EINES ELEKTRISCHEN ENERGIEVERSORGUNGSNETZES, INSBESONDERE EINES NIEDERSPANNUNGSNETZES**

(30) Priorität: 10.01.2019 DE 202019000225 U
(71) Anmelder: Siemens Aktiengesellschaft, 80333 München (DE)
(72) Erfinder: Kruß, Martin, 13591 Berlin (DE); Eckelmann, Florian, 14165 Berlin (DE); Werben, Stefan, 91207 Lauf a.d.P. (DE)

(57) **Zusammenfassung**

Die Erfindung betrifft eine Schutzanordnung (10) zur Überwachung eines elektrischen Energieversorgungsnetzes (11) mit einem Schutzgerät (12), wobei das Schutzgerät (12) mindestens einen Spannungseingang (14) zur Erfassung eines Spannungssignals unter Bildung von Spannungsmesswerten umfasst und wobei das Schutzgerät (12) eine Recheneinrichtung (18) umfasst, die dazu ausgebildet ist, zumindest anhand der Spannungsmesswerte einen aktuellen Betriebszustand des Energieversorgungsnetzes (11) zu erkennen und ein Fehlersignal zu erzeugen, wenn ein unzulässiger Betriebszustand vorliegt.

## Beschreibung

Die Erfindung betrifft eine Schutzanordnung zur Überwachung eines elektrischen Energieversorgungsnetzes mit einem Schutzgerät, wobei das Schutzgerät mindestens einen Spannungseingang zur Erfassung eines Spannungssignals unter Bildung von Spannungsmesswerten umfasst, und wobei das Schutzgerät eine Recheneinrichtung umfasst, die dazu ausgebildet ist, zumindest anhand der Spannungsmesswerte einen aktuellen Betriebszustand des Energieversorgungsnetzes zu erkennen und ein Fehlersignal zu erzeugen, wenn ein unzulässiger Betriebszustand vorliegt.

Elektrische Energieversorgungsnetze werden üblicherweise mit Hilfe sogenannter Schutzgeräte überwacht. Diese nehmen Messwerte von elektrischen Messgrößen auf, die einen Betriebszustand des Energieversorgungsnetzes charakterisieren, und werten diese Messwerte zur Erkennung des aktuellen Betriebszustands des Energieversorgungsnetzes aus. Beispielsweise kann als Messgröße eine elektrische Spannung verwendet werden. Die zugehörigen Messwerte werden beispielsweise mit geeigneten Schwellenwerten verglichen. Bei Überschreitung eines oberen Schwellenwertes wird ein Fehlersignal erzeugt, das zur Auslösung eines Schalters verwendet wird, um das Energieversorgungsnetz vor einer Überspannung zu schützen. In entsprechender Weise kann durch Vergleich mit einem unteren Schwellenwert ein Unterspannungsschutz realisiert werden.

Energieversorgungsnetze werden üblicherweise auf verschiedenen Spannungsebenen betrieben. Hoch- und Höchstspanungsnetze mit Spannungen über 60kV dienen dem Transport elektrischer Energie über weite Strecken. Mittelspannungsnetze (1kV - 35kV) werden zur Verteilung der elektrischen Energie und zum Anschluss von Großverbrauchern wie Industrieanlagen eingesetzt. Niederspannungsnetze auf einer Spannungsebene unter 1kV dienen schließlich zur Verteilung der elektrischen Energie an den Endverbraucher. Schutzgeräte für die Hoch- und Mittelspannungsebene bieten häufig sehr umfangreiche und aufwendige Schutzfunktionen, die über die soeben erläuterten Schutzfunktionen mit einfachen Schwellenwertvergleichen hinausgehen. So kann durch Auswertung von Messwerten von Strömen und Spannungen beispielsweise ein gerichteter Überstromschutz oder eine auf der elektrischen Leistung basierende Schutzfunktion realisiert werden. Die Spannungseingänge solcher Schutzgeräte werden normalerweise mit dem auf vergleichsweise hoher Spannung liegenden Hoch- bzw. Mittelspannungsnetz über Primärspannungswandler verbunden, die das für das Schutzgerät gefährlich hohe Spannungsniveau in eine niedrigere Spannung, üblicherweise unterhalb von 200V mit einem Nominalwert von 57,7V (100V Leiter-Leiter-Spannung), transformieren. Der Spannungseingang des Schutzgerätes ist dementsprechend hinsichtlich seiner sicherheitstechnischen Spezifikationen zum Anschluss an eine solche niedrige Spannung, z.B. unterhalb von 200V, ausgelegt. Diese sicherheitstechnischen Spezifikationen sind beispielsweise in der Niederspannungsrichtlinie 2014/35/EU bzw. EN 60255-27:2014, "Anforderungen an die Produktsicherheit von Messrelais und Schutzeinrichtungen", geregelt und definieren z.B. Minimalanforderungen bezüglich Luft- und Kriechstrecken sowie die elektrische Isolierung.

Schutzgeräte für Hoch- und Mittelspannungsnetze werden beispielsweise von der Siemens AG unter dem Namen "SIPROTEC" vertrieben.

Bisweilen besteht das Bedürfnis, ein solches für ein Hoch- bzw. Mittelspannungsnetz ausgelegtes Schutzgerät auch in einem Niederspannungsnetz einzusetzen. Allerdings ist der Anschluss über einen Primärspannungswandler aufgrund seiner hohen Anschaffungskosten für Anlagen auf dieser Spannungsebene preislich unattraktiv. Ein direkter Anschluss des Schutzgeräts an einen Leiter des Niederspannungsnetzes würde zu einer Verletzung der sicherheitstechnischen Auslegung führen, da die vorgesehenen Spezifikationen des Spannungseingangs eine Überschreitung der Bemessungsspannung nicht erlauben.

Dem Fachmann stellt sich somit die Aufgabe, eine Möglichkeit zu schaffen, wie ein herkömmliches Schutzgerät für Hoch- und Mittelspannungsnetze mit geringem Aufwand und damit auch kostengünstig quasi nachträglich an ein Niederspannungsnetz angeschlossen werden kann.

Diese Aufgabe wird durch eine Schutzanordnung der eingangs angegeben Art gelöst, bei der der Spannungseingang des Schutzgeräts im Normalbetrieb des Energieversorgungsnetzes zur Messung einer geringeren Spannung als der Maximalspannung des Spannungssignals ausgelegt ist und die Schutzanordnung einen Spannungsteiler aufweist, über den der Spannungseingang des Schutzgerätes direkt mit einem Leiter des elektrischen Energieversorgungsnetzes verbindbar ist, wobei der Spannungsteiler derart bemessen ist, dass die am Spannungseingang anliegende Spannung zu jedem Zeitpunkt innerhalb der Auslegungsgrenzen des Spannungseingangs liegt.

Erfindungsgemäß wird somit durch das Vorsehen eines zusätzlichen Spannungsteilers die Spannung des zu messenden Spannungssignals dauerhaft auf ein Niveau gesenkt, das dem Spannungseingang des Schutzgeräts ohne sicherheitstechnische Bedenken zugeführt werden kann. Wenn die Spezifikationen des Schutzgerätes beispielsweise einen direkten Anschluss einer Spannung von maximal 200V erlauben, kann durch eine entsprechende Ausgestaltung des Spannungsteilers eine Spannung des Spannungssignals auf einem Level unterhalb von 200V erreicht werden. Damit kann das Schutzgerät ohne die Notwendigkeit eines teuren Primärspannungswandlers direkt über den Spannungsteiler an einen Leiter des Niederspannungsnetzes angeschlossen werden.

Im Falle eines externen Spannungsteilers wird das Schutzgerät quasi als elektrische Last an den Spannungswandler angeschlossen.

Gemäß einer vorteilhaften Ausführungsform der erfindungsgemäßen Schutzanordnung kann vorgesehen sein, dass der Spannungseingang des Schutzgeräts eine vorgegebene Eingangsimpedanz aufweist, und die Schutzanordnung einen Vorwiderstand aufweist, der mit der Eingangsimpedanz des Spannungseingangs unter Bildung des Spannungsteilers zusammenwirkt.

Bei dieser Ausführungsform wird somit der Spannungsteiler aus Sicht des Schutzgerätes teilweise extern (durch den Vorwiderstand) und teilweise intern (durch die Eingangsimpedanz des Spannungseingangs) gebildet. Das Schutzgerät stellt damit einen Teil des Spanungsteilers selbst dar. Der Vorwiderstand sollte vorteilhafterweise impulsfest sein.

In diesem Zusammenhang kann gemäß einer vorteilhaften Weiterbildung der erfindungsgemäßen Schutzanordnung vorgesehen sein, dass die Anordnung eine Klemme aufweist, über eine elektrische Verbindung des Spannungseingangs mit dem Leiter des elektrischen Energieversorgungsnetzes herstellbar ist und der Vorwiderstand in der Klemme integriert ist.

Durch die Integration des Vorwiderstandes in die Klemme können gleichzeitig Verschaltungsaufwand und Platzbedarf minimiert werden.

Konkret kann hierbei beispielsweise vorgesehen sein, dass der Vorwiderstand in einem Bauelementestecker aufgenommen ist, der lösbar in die Klemme eingesetzt ist.

Auf diese Weise kann durch Verwendung handelsüblicher Bauteile auf einfache Weise und kostengünstig der Spannungsteiler realisiert werden.

Eine weitere vorteilhafte Ausführungsform der erfindungsgemäßen Schutzanordnung sieht im Zusammenhang mit der Klemme vor, dass die Klemme eine Trennklemme eines Schaltschrankes ist, der das Schutzgerät umfasst.

Solche "Trennklemmen" werden in Schaltschränken vorgesehen, um die interne Verdrahtung des Schaltschrankes, zu der auch die Verdrahtung mit im Schaltschrank vorgesehenen Schutzgeräten gehört, mit externen Anschlüssen zu verbinden.

Hinsichtlich der Ausgestaltung des Spannungsteilers kann konkret vorgesehen sein, dass der ohmsche Widerstandswert des Vorwiderstands die Hälfte des ohmschen Widerstands der Eingangsimpedanz des Spannungseingangs beträgt.

Eine solche Bemessung des Spannungsteilers vereinfacht die nachfolgende rechnerische Verarbeitung der Spanungsmesswerte.

Gemäß einer weiteren vorteilhaften Ausführungsform kann zudem vorgesehen sein, dass die Recheneinrichtung des Schutzgerätes dazu ausgebildet ist, die Spannungsmesswerte mit einem Anpassungsfaktor zu multiplizieren, dessen Wert dem inversen Wert des Spannungsteilers entspricht.

Als Wert des Spanungsteilers wird hierbei dessen Übersetzungsverhältnis angesehen, also beispielsweise 1:2 bei einem Spannungsteiler mit einer Eingangsimpedanz von jeweils 100kΩ und einem Vorwiderstand von ebenfalls 100 kΩ. Bei dieser Ausführungsform wird somit die durch den Spannungsteiler real vorgenommene Reduzierung des Spannungssignals rechnerisch wieder ausgeglichen. Diese Ausführungsform wird als besonders vorteilhaft angesehen, da die im Schutzgerät verwendeten Schwellenwerte und Parameter an die tatsächlichen Gegebenheiten des Spannungssignals (vor dem Spannungsteiler) angepasst werden können. Dies vereinfacht die Konfiguration des Schutzgerätes, da die einzustellenden Parameterwerte nicht entsprechend des Wertes des Spannungsteilers umgerechnet werden müssen, sondern intuitiv die Spannungswerte vor dem Spannungsteiler, die den Gegebenheiten im Energieversorgungsnetz entsprechen, verwendet werden können.

Gemäß einer weiteren vorteilhaften Ausführungsform kann zudem vorgesehen sein, dass das Schutzgerät zumindest einen Stromeingang zur Erfassung eines Stromsignals unter Bildung von Strommesswerten umfasst, und die Recheneinrichtung des Schutzgerätes dazu ausgebildet ist, anhand der Strommesswerte und der Spannungsmesswerte den aktuellen Betriebszustand des Energieversorgungsnetzes zu erkennen.

Auf diese Weise können komplexe Schutzfunktionen, die sowohl Spannungs- als auch Strommesswerte benötigen, realisiert werden.

Schließlich ist gemäß einer weiteren vorteilhaften Ausführungsform vorgesehen, dass das Energieversorgungsnetz ein Niederspannungs-Energieversorgungsnetz ist.

Die Erfindung wird nachfolgend anhand eines Ausführungsbeispiels näher erläutert. Die spezifische Ausgestaltung des Ausführungsbeispiels ist für die allgemeine Ausgestaltung der erfindungsgemäßen Schutzanordnung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen
- Figur 1: einen schematischen Schaltplan einer Schutzanordnung; und
- Figur 2: eine beispielhafte Ansicht einer Trennklemme mit einsetzbarem Vorwiderstand.

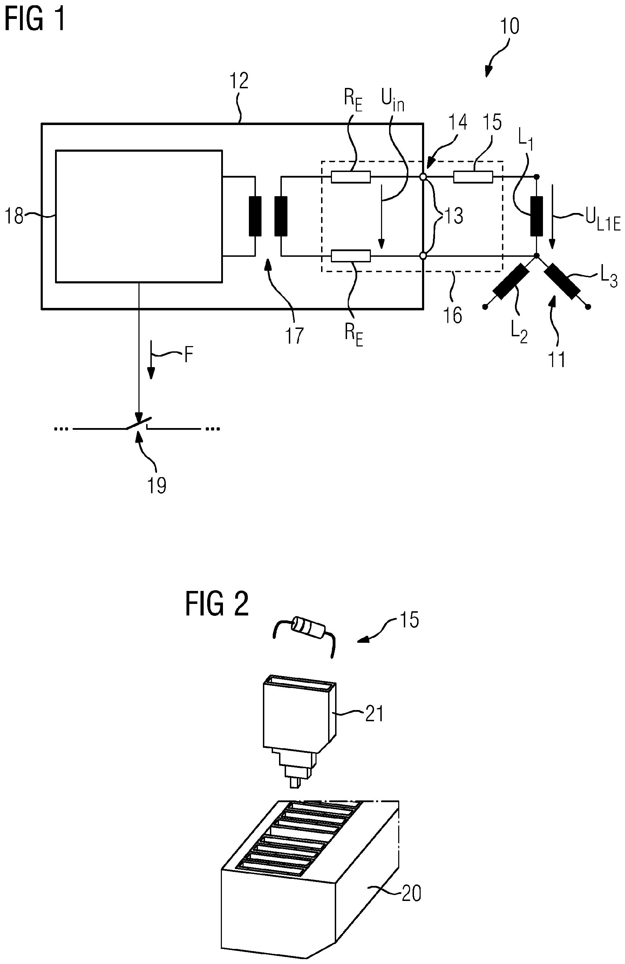

Figur 1 zeigt einen schematischen Schaltplan einer Schutzanordnung 10, die an ein lediglich angedeutetes Energieversorgungsnetz 11, das beispielhaft als dreiphasiges Niederspannungsnetz dargestellt ist, angeschlossen ist. An dem Energieversorgungsnetz 11 wird ein Spannungssignal abgegriffen, das im vorliegenden Beispiel eine Leiter-Erde-Spannung U_{L1E} darstellt. Dieses Spanungssignal ist dazu geeignet, einen Betriebszustand des Energieversorgungsnetzes zu charakterisieren. Zusätzlich oder alternativ zu dem in Figur 1 angedeuteten Spannungssignal U_{L1E} können auch Spannungssignale anderer Leiter-Erde-Spannungen U_{L2E}, U_{L2E} und/oder Leiter-Leiter-Spannungen erfasst werden.

Das Spannungssignal wird einem Schutzgerät über dessen Eingangsklemmen 13 eines Spannungseingangs 14 zugeführt. Dabei ist das Schutzgerät 12 originär für die Verwendung in einem Mittel- oder Hochspannungsnetz ausgelegt, so dass die technische Spezifikation des Spannungseingangs (z.B. hinsichtlich Kriechstrecken, Luftstrecken, Isolation) einem Spannungssignal entspricht, dessen Höhe im Normalbetrieb des Energieversorgungsnetzes einen gewissen Wert (z.B. maximal 200V) nicht überschreitet. Zu diesem Zweck werden in Hoch- und Mittelspannungsnetzen üblicherweise Primärwandler eingesetzt, die in unmittelbarer Nähe des Energieversorgungsnetzes die erfasste Spannung auf ein niedrigeres Niveau, z.B. bis zu einem Nominalwert von 57,7V, transformieren, das der Auslegung des Spannungseingangs entspricht.

Wenn das Schutzgerät 12 direkt an ein Energieversorgungsnetz 11 mit einem geringeren Spannungsniveau als einem Mittel- oder Hochspannungsnetz angeschlossen werden soll, könnten prinzipiell ebenfalls Primärwandler eingesetzt werden. Dies soll aufgrund der hohen Kosten solcher Primärwandler jedoch vermieden werden. Ein direkter Anschluss des Spannungseingangs 14 kommt jedoch nur dann in Frage, wenn das erfasste Spannungssignal innerhalb der Auslegungsgrenzen des Spannungseingangs 14 liegt. Andernfalls bestünden sicherheitstechnische Risiken für das Schutzgerät und seine Umgebung inklusive dem Bedienpersonal. Daher weist die Schutzanordnung 10 einen Vorwiderstand 15 auf, der gemeinsam mit einer Eingangsimpedanz des Spannungseingangs 14 (in der Figur 1 schematisch als Widerstände R_{E} angedeutet) einen Spannungsteiler 16 bildet, der so ausgelegt ist, dass sein ausgangsseitiges Spannungssignal Uᵢₙ zu jeder Zeit innerhalb der Auslegungsgrenzen des Spannungseingangs 14 liegt, so dass insbesondere Luft- und Kriechstrecken sowie Anforderungen an die Isolation eingehalten werden.

Zur elektrischen Entkopplung wird das Spannungssignal Uᵢₙ daraufhin einem im Schutzgerät 12 integrierten Wandler 17 zugeführt. Durch Abtastung mit einer (nicht gezeigten) Abtasteinrichtung werden hieraus Spannungsmesswerte gewonnen, die einer nachgeschalteten Recheneinrichtung 18 zugeführt werden. Die Recheneinrichtung 18 führt anhand der Spannungsmesswerte eine Auswertung bezüglich des Betriebszustands des Energieversorgungsnetzes 11 durch und erzeugt ein Fehlersignal F, sofern ein unzulässiger Betriebszustand erkannt worden ist. Das Fehlersignal F kann einer Schalteinrichtung 19 des Energieversorgungsnetzes 11 zugeführt werden, um im Fehlerfall eine Stromversorgung des betroffenen Abschnitts des Energieversorgungsnetzes zu unterbrechen.

Die Recheneinrichtung 18 kann außerdem dazu eingerichtet sein, die Spannungsmesswerte vor einer weiteren Verarbeitung mit einem Anpassungsfaktor zu multiplizieren, der invers zu dem Wert des Spannungsteilers ist. Hat beispielsweise der Spannungsteiler einen Wert von 1:2, so muss als Anpassungsfaktor ein Wert von 2 verwendet werden. Auf diese Weise wird die durch den Spannungsteiler real vorgenommene Reduzierung der Spannung rechnerisch wieder ausgeglichen, so dass innerhalb der Recheneinrichtung 18 mit Parametern (z.B. Schwellenwerten) gerechnet werden kann, die dem Spannungssignal vor dem Spannungsteiler entsprechen.

Das Schutzgerät 12 kann selbstverständlich mehr als einen Spannungseingang aufweisen, der entsprechend über einen Vorwiderstand an das Energieversorgungsnetz angeschlossen ist.

Neben dem Spannungseingang kann das Schutzgerät 12 auch mindestens einen Stromeingang aufweisen, mit dem ein Stromsignal erfasst wird, aus dem durch Abtastung Strommesswerte gewonnen werden. Die Recheneinrichtung 18 kann dann unter Verwendung der Spannungs- und der Strommesswerte den Betriebszustand des Energieversorgungsnetzes bestimmen.

Das beschriebene Schutzgerät 12 kann auf diese Weise verschiedene Schutzfunktionen bezüglich des Energieversorgungsnetzes 11 ausführen. Beispielsweise können die Spannungsmesswerte direkt ausgewertet werden, um eine Über- oder Unterspanungsschutzfunktion zu realisieren. Durch Hinzunahme von Strommesswerten kann eine Richtungserkennung zur Ermittlung der Lage eines Fehlers und/oder eine Bestimmung einer elektrischen Leistung durchgeführt werden. Darüber hinaus können weitere Schutzfunktionen eingesetzt werden, die direkt auf die Spannungsmesswerte oder von diesen abgeleitete Werte sowie ggf. Messwerte anderer Größen zurückgreifen. Für die Anwendung in Niederspanungsnetzen besonders relevante und auf einer Spannungsmessung basierende Schutzfunktionen sind beispielsweise ein gerichteter Überstromzeitschutz, ein Rückleistungsschutz, ein Über- bzw. Unterspannungsschutz, die Aufzeichnung von Störschrieben zur nachgelagerten Analyse eines Fehlers sowie allgemeine Betriebsgrößenmessungen von Spannungen, Leistungen und Energie.

Figur 2 zeigt beispielhaft einen Vorwiderstand 15. Als Vorwiderstand 15 sollte ein impulsfester Widerstand mit einem ohmschen Widerstandswert verwendet werden, der der Auslegung des Spannungsteilers entspricht. Beispielsweise kann als Vorwiderstand ein Widerstand eingesetzt werden, dessen ohmscher Widerstandswert die Hälfte der Eingangsimpedanz des Spannungseingangs entspricht (z.B. 100kΩ bei einer gesamten Eingangsimpedanz von 200kΩ). Der Vorwiderstand 15 kann dabei platzsparend in einer Trennklemme 20 eingebaut sein. Um eine leicht zu montierende und demontierbare Möglichkeit zu schaffen, kann der Widerstand in einem Bauelementestecker 21 eingesetzt sein, der in einfacher Weise in die Trennklemme 20 eingesteckt werden kann. Die Trennklemme 20 kann beispielsweise in einem Schaltschrank vorgesehen sein, um die innere Schrankverdrahtung mit externen Anschlüssen zu verbinden.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

## Patentansprüche

1. Schutzanordnung (10) zur Überwachung eines elektrischen Energieversorgungsnetzes (11) mit einem Schutzgerät (12), wobei
- das Schutzgerät (12) mindestens einen Spannungseingang (14) zur Erfassung eines Spannungssignals unter Bildung von Spannungsmesswerten umfasst; und wobei
- das Schutzgerät (12) eine Recheneinrichtung (18) umfasst, die dazu ausgebildet ist, zumindest anhand der Spannungsmesswerte einen aktuellen Betriebszustand des Energieversorgungsnetzes (11) zu erkennen und ein Fehlersignal zu erzeugen, wenn ein unzulässiger Betriebszustand vorliegt,
**dadurch gekennzeichnet, dass**
- der Spannungseingang (14) des Schutzgeräts (12) im Normalbetrieb des Energieversorgungsnetzes (11) zur Messung einer geringeren Spannung als der Maximalspannung des Spannungssignals ausgelegt ist; und
- die Schutzanordnung (10) einen Spannungsteiler (16) aufweist, über den der Spannungseingang (14) des Schutzgerätes (12) direkt mit einem Leiter des elektrischen Energieversorgungsnetzes (11) verbindbar ist, wobei der Spannungsteiler (16) derart bemessen ist, dass die am Spannungseingang (14) anliegende Spannung zu jedem Zeitpunkt innerhalb der Auslegungsgrenzen des Spannungseingangs (14) liegt.

2. Schutzanordnung (10) nach Anspruch 1,
**dadurch gekennzeichnet, dass**
- der Spannungseingang (14) des Schutzgeräts (12) eine vorgegebene Eingangsimpedanz aufweist; und
- die Schutzanordnung (10) einen Vorwiderstand (15) aufweist, der mit der Eingangsimpedanz des Spannungseingangs (14) unter Bildung des Spannungsteilers (16) zusammenwirkt.

3. Schutzanordnung (10) nach Anspruch 2,
**dadurch gekennzeichnet, dass**
- die Anordnung eine Klemme aufweist, über eine elektrische Verbindung des Spannungseingangs (14) mit dem Leiter des elektrischen Energieversorgungsnetzes (11) herstellbar ist; und
- der Vorwiderstand (15) in der Klemme integriert ist.

4. Schutzanordnung (10) nach Anspruch 3,
**dadurch gekennzeichnet, dass**
- der Vorwiderstand in einem Bauelementestecker aufgenommen ist, der lösbar in die Klemme eingesetzt ist.

5. Schutzanordnung (10) nach Anspruch 3 oder 4,
**dadurch gekennzeichnet, dass**
- die Klemme eine Trennklemme (20) eines Schaltschrankes ist, der das Schutzgerät (12) umfasst.

6. Schutzanordnung (10) nach einem der Ansprüche 2 bis 5,
**dadurch gekennzeichnet, dass**
- der ohmsche Widerstandswert des Vorwiderstands (15) die Hälfte des ohmschen Widerstands der Eingangsimpedanz des Spannungseingangs (14) beträgt.

7. Schutzanordnung (10) nach einem der vorangehenden Ansprüche,
**dadurch gekennzeichnet, dass**
- die Recheneinrichtung (18) des Schutzgerätes (12) dazu ausgebildet ist, die Spannungsmesswerte mit einem Anpassungsfaktor zu multiplizieren, dessen Wert dem inversen Wert des Spannungsteilers (16) entspricht.

8. Schutzanordnung (10) nach einem der vorangehenden Ansprüche,
**dadurch gekennzeichnet, dass**
- das Schutzgerät (12) zumindest einen Stromeingang zur Erfassung eines Stromsignals unter Bildung von Strommesswerten umfasst; und
- die Recheneinrichtung (18) des Schutzgerätes (12) dazu ausgebildet ist, anhand der Strommesswerte und der Spannungsmesswerte den aktuellen Betriebszustand des Energieversorgungsnetzes (11) zu erkennen.

9. Schutzanordnung (10) nach einem der vorangehenden Ansprüche,
**dadurch gekennzeichnet, dass**
- das Energieversorgungsnetz (11) ein Niederspannungs-Energieversorgungsnetz ist.
